# EUROPÄISCHE PATENTSCHRIFT

(11) **EP 2 859 658 B1**
(45) Veröffentlichungstag und Bekanntmachung des Hinweises auf die Patenterteilung: **08.11.2017**
(21) Anmeldenummer: 13728688.6
(22) Anmeldetag: 29.05.2013
(51) Int. Cl.: H03K 17/955, G01D 5/24, H03K 17/96, E05F 15/73

(54) **KAPAZITIVE SENSORANORDNUNG ZUR SCHALTUNG EINER TÜRÖFFNUNG AN EINEM KRAFTFAHRZEUG**
CAPACITIVE SENSOR ARRANGEMENT FOR SWITCHING A DOOR OPENING ON A MOTOR VEHICLE
ENSEMBLE CAPTEUR CAPACITIF POUR ACTIONNER UNE OUVERTURE DE PORTE AU NIVEAU D'UN VÉHICULE AUTOMOBILE

(30) Priorität: 06.06.2012 DE 102012104916
(43) Veröffentlichungstag der Anmeldung: 15.04.2015
(73) Patentinhaber: Huf Hülsbeck & Fürst GmbH & Co. KG, 42551 Velbert (DE)
(72) Erfinder: SCHINDLER, Mirko, 42549 Velbert (DE); PESCHL, Andreas, 42555 Velbert (DE); VAN GASTEL, Peter, 42699 Solingen (DE)
(74) Vertreter: Zenz Patentanwälte Partnerschaft mbB
(86) Internationale Anmeldenummer: PCT/EP2013/061080
(87) Internationale Veröffentlichungsnummer: WO 2013/182464

(56) Entgegenhaltungen:
- WO-A1-01/08925
- DE-A1-102010 002 559

## Beschreibung

Die Erfindung betrifft eine kapazitive Sensoranordnung mit einer Sensorelektrode, mit deren Hilfe das Eindringen eines Objekts in einen Raum vor der Sensorelektrode erfasst wird. Eine mit der Sensorelektrode gekoppelte Steuer- und Auswerteschaltung erfasst eine Änderung der Kapazität der Sensorelektrode gegenüber einem Referenzpotential, indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Die Sensorelektrode reagiert dabei auf Annäherungen bzw. Berührungen von Objekten durch eine Kapazitätsänderung des aus der Sensorelektrode und dem Objekt gebildeten Kondensators. Dies lässt sich im Kern darauf zurückführen, dass die Kapazität eines Kondensators von seinem Plattenabstand abhängt. Im Regelfall erhöht sich dessen Kapazität je näher das Objekt der Sensorelektrode kommt.

Eine kapazitive Sensoranordnung mit einer Sensorelektrode, mit deren Hilfe die Annäherung eines Objekts erfasst werden soll, und mit einer mit der Sensorelektrode gekoppelten Steuer- und Auswerteschaltung, die eine Änderung der Kapazität der Sensorelektrode gegenüber Masse erfasst, indem sie die Sensorelektrode mit einer vorgegebenen Frequenz periodisch wiederholt mit einer Betriebsspannung koppelt und wenigstens einen Parameter eines vom periodischen Laden und Entladen der Sensorelektrode abhängigen Strom- oder Spannungsverlaufs zur Erfassung der Kapazitätsänderung auswertet, ist beispielsweise aus dem US-Patent 5,730,165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt.

Das Dokument DE 10 2010 002 559 A1 offenbart eine Sensorelektrode für eine Bedienungserkennung, wobei die Sensorelektrode eine Flachelektrode mit variierender Breite ist.

Die WO 01/08925 beschreibt einen kapazitiven Sensor mit einer langgestreckten Elektrode, wobei die Elektrode entlang ihrer Längserstreckung unterschiedlich breite Abschnitte aufweist.

Bei kapazitiven Sensoren werden Kapazitätsänderungen auch als Variationen der Auflade- und/oder Entladezeit der Kapazität einer Sensorelektrode ermittelt. Beispielsweise arbeitet der Sensor nach dem Ladungstransferprinzip. Eine Auswerteelektronik nach dem Ladungstransferprinzip benötigt dabei wenigstens einen Referenzkondensator welcher turnusmäßig aufgeladen wird, wobei die Aufladezeit bestimmt wird und als Referenzzeitspanne für die Auswertung von Annäherungen oder Berührungen eines Objektes verwendet wird. Es werden also Änderungen der Aufladezeit des Referenzkondensators ausgewertet, die durch Annäherungen eines Objektes an die Sensorelektrode modifiziert werden.

Eine kapazitive Sensoranordnung mit einer Sensorelektrode, mit einer beabstandet hinter der Sensorelektrode angeordneten Masse-Hintergrundelektrode und mit einer Schirmelektrode, die zwischen der Sensorelektrode und der Masse-Hintergrundelektrode angeordnet ist und die über eine Steuer- und Auswerteschaltung derart mit der Sensorelektrode gekoppelt ist, dass ihr Potential dem Potential der Sensorelektrode nachgeführt wird, ist beispielsweise aus den Veröffentlichungen EP 0 518 836 A1, US 6,825,752 B2, DE 101 31 243 C1 und DE 10 2006 044 778 A1 bekannt. Das aus diesen Druckschriften bekannte Vorsehen einer Schirmelektrode zwischen der Sensorelektrode und der auf Masse-Potential liegenden Hintergrundelektrode hat den Vorteil, dass die Empfindlichkeit des so gebildeten kapazitiven Sensors gegenüber Veränderungen im Raum vor der Sensorelektrode, beispielsweise durch Einbringen von Objekten, erhöht wird. Dies liegt vor allem daran, dass sich das von der Sensorelektrode ausbreitende Feld stärker in den Raum vor der Sensorelektrode (Detektionsbereich) erstreckt, weil nicht mehr - wie bei fehlender Schirmelektrode - ein großer Teil des Feldes zu der auf Masse-Potential liegenden Hintergrundelektrode kurzgeschlossen wird. Aufgrund des Umstands, dass die Schirmelektrode derart mit der Sensorelektrode gekoppelt ist, dass sie deren Potential nachgeführt wird, entsteht das starke elektrische Feld zwischen der Schirmelektrode und der Hintergrundelektrode; vor allem aber bildet sich praktisch kein Feld aus zwischen der Sensorelektrode und der potentialmäßig nachgeführten Schirmelektrode.

Die bekannte Anordnung von Sensorelektrode, Schirmelektrode und Hintergrundelektrode ist üblicherweise von einem elektrischen Isolator, beispielsweise einem Kunststoff, umhüllt, so dass sich eine Isolatorschicht, beispielsweise Kunststoffschicht, auf der Sensorelektrode und somit zwischen der Sensorelektrode und dem zu überwachenden Raum vor der Sensorelektrode, das heißt dem Detektionsbereich, befindet.

Derartige Sensorelektroden können verwendet werden, um eine Tür oder Klappe eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten. Es sind auch Sensorelektroden mit Flachbandkabel bekannt, z.B. aus der DE 10 2010 027 872.

Ein Problem mit den bekannten Einrichtungen besteht darin, dass es zu Fehlerkennungen kommen kann, welche unerwünschte Schalt- bzw. Betätigungsvorgänge auslösen, wenn Bewegungen von Gegenständen durch die Sensorik fehlinterpretiert werden. Auch missverstandene Bewegungen eines Benutzers hinter einem Fahrzeug, z.B. bei Umgreifen von getragenen Lasten, können, als Öffnungssignal aufgefasst, zu Problemen führen. Außerdem ist die Anordnung der bisher bekannten Sensorelektroden am Fahrzeug raumbeanspruchend und aufwändig.

Aufgabe der Erfindung ist es daher, eine verlässliche Sensorik bereitzustellen, welche die Fehlerfassungen von Betätigungsanforderungen reduziert und welche raumsparend und flexibel am Fahrzeug anzubringen ist.

Erfindungsgemäß wird diese Aufgabe durch eine kapazitive Sensoranordnung mit den Merkmalen des Anspruchs 1 gelöst.

Die erfindungsgemäße Sensoranordnung zur Erfassung von Bewegungsgesten an einem Kraftfahrzeug hat wenigstens eine kapazitive Sensorelektrode und wenigstens eine mit der Sensorelektrode gekoppelte Steuer- und Auswerteeinrichtung, welche eine Änderung der Kapazität der Sensorelektrode erfasst. Die Sensorelektrode ist als langgestreckte Flachelektrode ausgebildet, wobei sich in Längsrichtung sensitivere Elektrodenabschnitte mit einer ersten Flächenbreite mit weniger sensitiven Abschnitten einer zweiten, geringeren Flächenbreite abwechseln, so dass abschnittsweise durchgehend leitende, jedoch unterschiedlich sensitive Elektrodenflächen mit unterschiedlichen Abmessungen gebildet sind.

Es ist außerdem eine weitere langgestreckte Elektrode vorgesehen, welche mit derselben Steuer- und Auswerteeinrichtung gekoppelt ist, wobei die weitere Elektrode ebenfalls Bereiche unterschiedlicher Flächenbreite aufweist.

Die erfindungsgemäße kapazitive Sensoranordnung umfasst demnach sich entlang einer ersten Koordinatenlinie erstreckende erste und zweite Sensorelektroden, mit deren Hilfe das Eindringen eines Objekts in einen Raum vor der ersten Sensorelektrode erfasst werden soll. Die Koordinatenlinie ist beispielsweise eine gerade Koordinatenlinie eines kartesischen Koordinatensystems; sie kann aber auch im Raum gekrümmt sein. Zur Unterscheidung der Raumrichtungen wird im Weiteren davon ausgegangen, dass die Elektroden sich mit ihrer größten Ausdehnung, der Längserstreckung in Richtung einer z-Achse erstrecken. Die Sensorelektroden bestehen aus einem elektrisch leitenden Material oder einer Kombination von elektrisch leitenden Materialien und sind als Flachelektrode ausgebildet. Dies bedeutet, dass die Elektroden in einer Raumorientierung (hier als x-Achse definiert) eine Stärke aufweisen, die wenigstens eine Größenordnung geringer ist als die maximale Erstreckung in den beiden dazu senkrechten Raumrichtungen (also der z-Achse und der Y-Achse). Entsprechend dieser Definition dehnen sich die Elektroden als flächige Elektroden in der yz-Ebene aus, während sie in der x-Richtung nur geringe Dicke aufweisen. Die Flachelektroden weisen außerdem Bereiche unterschiedlicher Flächenausdehnung in Richtung der Längserstreckung auf. Bereiche mit eingeschnürter Flächenausdehnung wechseln sich mit Bereichen vergrößerter Flächenausdehnung ab. Die Elektrodenfläche entlang der Längserstreckung ist also in verschiedenen Abschnitten unterschiedlich.

Zumindest die ersten Abschnitte der Elektrode sind als integrale Leiterabschnitte ausgeführt. Die zweiten Abschnitte können, wie unten beschrieben, ebenfalls integral ausgebildet sein. Dann kann die gesamte Elektrode z.B. durch stanzen oder lasern aus einem Leiterblech gebildet sein. Die zweiten Abschnitte können jedoch auch aus anderen elektrisch leitenden Kopplungsmitteln gebildet sein (z.B. auch mehradrig).

Die Bereiche geringerer Flächenbreite, also geringerer Breite quer zur Längserstreckung, sind leichter Verformbar als die Bereiche mit größerer Flächenbreite.

Mit den Vergleichsbezeichnungen "größer" und "geringer" oder "kleiner" sollen die Verhältnisse der Abmessungen untereinander bestimmt werden. Es soll also gesagt werden, dass die ersten Abschnitte breiter sind als die zweiten Abschnitte und die erste Verformbarkeit geringer ist als die zweite Verformbarkeit. Wesentlich ist, dass gezielt Bereiche mit größerer Verformbarkeit in der Flachelektrode gebildet sind, welche eine Flexibilität der Flachelektrode verbessern und die Anpassung des Elektrodenverlaufs an Fahrzeugkonturen erlaubt.

Eine verformbare, flache und elektrisch isolierende Ummantelung der Sensorelektrode ist zum Umschließen der Elektrode gebildet.

Durch diese Bauart wird einerseits eine sehr flache und platzsparende Elektrode gebildet. Außerdem wirkt die Elektrode mit ihrer Formgebung des durchgehenden Leiters ähnlich wie eine Zusammenschaltung von Kondensatorplatten unterschiedlicher Größe. Durch die verjüngten Abschnitte (kleinere Kondensatorplatten) werden die Bereiche größerer Flächenausdehnung (größerer Kondensatorplatten) verbunden. Da die Flächenbereiche elektrisch leitend verbunden sind, findet grundsätzlich ein Potenzialausgleich auf der Elektrode und ein Ausgleich der Flächenladung statt. Entsprechend reagieren die Bereiche größerer flächiger Ausdehnung stärker als die verjüngten Bereiche auf Annäherungen.

Durch die flächige Gestaltung wird außerdem eine optimierte Ausrichtung der Elektrode erreicht. Die Elektrode wird mit ihrer flächigen Seite in Richtung des Detektionsbereiches gerichtet. Diese Empfangsfläche oder Wirkungsfläche ist dann effektiver einsetzbar als bisherige Rundelektroden, da die Kondensatorplatte (Flachseite der Flachelektrode) auf den Detektionsbereich ausgerichtet wird.

Die Gesamtsensitivität der Elektrode wird gegenüber den bisher häufig verwendeten Kabelelektroden (z.B. Koaxialkabel) verbessert, was in der flächigen Ausbildung und optimierten Orientierung begründet ist. Während herkömmliche Flachelektroden jedoch oft nicht flexibel in wenigstens einer Richtung quer zu ihrer Längserstreckung waren, ist die erfindungsgemäße Flachelektrode dank der verjüngten oder schmaleren Bereiche in ihrer Flexibilität stark verbessert.

Die breiteren Bereiche können wiederum dank der durch die schmalen Bereiche vermittelten Flexibilität breiter ausgeführt werden als bei Verwendung einer gleichförmigen Flachelektrode. Dies überkompensiert die Sensitivitätsverluste in den schmalen Bereichen. Die erfindungsgemäße Elektrode ist sowohl besonders sensitiv als auch besonders Flexibel.

Das umgebende verformbare Material schützt vor Umwelteinflüssen und Kontakt mit elektrisch leitenden Bauteilen.

Außerdem kann die Ummantelung eine Kraftverteilung bei Verformung der Elektrode bewirken, welche Knicken der Elektrode oder ungleichmäßigen Verformungen vorbeugt. Die Ummantelung kann dafür insbesondere eng an der Elektrode anliegen, was z.B. durch Umspritzen, einschrumpfen oder gemeinsames Extrudieren mit der flachen Elektrode als Seele erreicht wird. Entsprechende Verfahren und zugehörige Materialien sind in der Technik z.B. im Bereich der Türdichtungen bekannt. Hierzu wird beispielhaft auf die DE 10 2009 021 225 verwiesen.

Weiterhin ist die Elektrode einfach an die Einpassung in verschiedenen Kraftfahrzeugen anpassbar. Die verjüngten Bereiche lassen sich leicht Verformen und die Elektrode ist entlang einer 3D-Raumlinie im Heckbereich anzuordnen. Das verformbare Ummantelungsmaterial vollzieht die Verformungen mit ohne zu brechen oder zu reißen.

Im Gegensatz zu Elektroden, die entlang ihrer Längserstreckung unabhängige, nicht verbundene Elektrodenabschnitte zur Raumauflösung aufweisen, ist die erfindungsgemäße Elektrode außerdem grundsätzlich auf eine gewünschte Länge kürzbar.

Um die funktionalen Vorteile der erfindungsgemäßen Elektrode zu erläutern wird davon ausgegangen, dass eine mit der Sensorelektrode gekoppelte Steuer- und Auswerteschaltung vorhanden ist. Die erfasst eine Änderung der Kapazität der Sensorelektrode gegenüber einem Referenzpotential, indem sie die erste Sensorelektrode mit einer vorgegebenen Frequenz periodisch auf- und entlädt und wenigstens einen Parameter eines vom periodischen Laden und Entladen der ersten Sensorelektrode abhängigen Strom- oder Spannungsverlaufs zur Erfassung der Kapazitätsänderung auswertet. Das periodische Auf- und Entladen führt sie beispielsweise aus, indem sie die Sensorelektrode mit der vorgegebenen Frequenz periodisch wiederholt mit einem vorgegebenen Potential, beispielsweise dem Betriebsspannungspotenzial, koppelt. Der Spannungsverlauf kann beispielsweise der Spannungsverlauf am Anschluss der ersten Sensorelektrode sein. Der Parameter kann beispielsweise eine Spannung, die über einem Ladung ansammelnden Kondensator gemessen wird, oder eine bestimmte Anzahl von Perioden des Ladens und Entladens bis zum Überschreiten einer Schaltschwelle durch eine an der ersten Sensorelektrode gemessene Spannung sein.

Die erfindungsgemäße Flachelektrode weist entlang ihrer Erstreckung Bereiche mit unterschiedlicher kapazitiver Sensitivität auf, wie oben beschrieben. Ein Körperteil, welches entlang der Sensorelektrode bewegt wird, erzeugt je nach Position entsprechend unterschiedliche Signale in der Auswerteeinrichtung. Diese Einrichtung erlaubt daher die Detektion einer Annäherung und außerdem eine Detektion einer Bewegung entlang der erfindungsgemäß geformten Elektrodenanordnung durch wiederholtes Abfragen dieser geformten Elektrodenanordnung, z.B. alle 5ms bis 15ms. Dadurch können Bewegungen, welche eine Bedienungsgeste darstellen von anderen Bewegungen sicherer unterschieden werden. Insbesondere ist zu überwachen, ob die zeitliche Folge von Kapazitätswerten charakteristische Veränderungen aufweist, z.B. Wendepunkte.

Eine vorgegebene Geste eines Benutzers, z.B. ein angetäuschter Kick unter den Stossfänger, soll zu einem Öffnungs- oder Schließvorgang führen. Dazu wird die Sensorelektrode abgefragt, ob das zeitliche Signalmuster charakteristisch für eines solche Bewegung ist, im genannten Beispiel also eine Annäherung des Unterschenkels eines Benutzers detektiert und zu ansteigenden Signalwerten führt.

Die Länge der Abschnitte verschiedener Breite ist von der Anwendung abhängig. Allerdings sollte die Länge der breiteren und schmaleren Abschnitte der gewünschten Auflösung der Erfassung angepasst sein. Es wird daher sinnvoll sein, die verjüngten Bereiche, also den Abstand zwischen den breiteren Bereich zu einigen cm, z.B. 10-25cm zu wählen, um etwa die Abmessungen eines Unterschenkels bei der Bedienung aufzulösen.

In einer bevorzugten Gestaltung ist die isolierende Ummantelung mit einer oder mehreren Funktionsschichten versehen, z.B. Abschirmungslagen für die Sensorelektrode oder kontaktierbaren aktiven Richtelektroden, welche dasselbe Potenzial haben, wie die Sensorelektrode.

Außerdem weist die isolierende und verformbare Ummantelung in einer bevorzugten Ausführungsform äußere Markierungen auf, welche die Lage der breiteren und der Verjüngten Bereiche entlang der Längserstreckung markieren. Dadurch kann die in langen Stücken produzierte Elektrode (z.B. durch einen Extrusionsvorgang) in passende Abschnitte geteilt werden. Die Bereiche geringer Breite eignen sich dabei insbesondere als Trennstellen. An diesen Trennstellen kann die Kontaktierung mit Klemmen oder gekrimpten Mitteln vorgenommen werden.

In diesem Zusammenhang sind bei der Sensorelektrode Bereiche erster Art mit einheitlichen Abmessungen ausgebildet, so dass alle breiteren Abschnitte einheitlich ausgebildet sind. Vorzugsweise sind auch alle schmaleren Abschnitte einheitlich ausgebildet sind. Dies ermöglicht eine Auftrennung der Elektroden in gewünschter Länge, ohne auf die konkrete Art des Breiten Abschnitts zu achten.

An dieser Stelle ist anzumerken, dass es bei anwendungsspezifisch gefertigten Elektroden auch sein kann, dass breitere Abschnitte verschiedener Längenabmessung realisiert werden, z.B. um die schmaleren Bereiche auf solche Abschnitte zu konzentrieren, welche bei Montage stärkste Biegungen erfahren müssen.

In einer Ausführungsform sind die ersten Elektrodenabschnitte aus einem anderen Material gebildet sind als die zweiten Elektrodenabschnitte. Die Wahl eines leitenden, leicht verformbaren Materials für die zweiten Elektrodenabschnitte verbessert die Flexibilität der Elektrode weiter. Da es in diesen Bereichen nur nachgeordnet auf die kapazitive Sensitivität ankommt, können die zweiten Abschnitte z.B. auch aus leitendem Kunststoff oder einem ein- oder mehradrigen Flachkabel bestehen, welches entlang einer Anordnung von breiten Abschnitten (z.B. Metallplatten) in Kontakt mit diesen gebracht wird (z.B. aufgelegt oder gelötet) und anschließend umspritzt, getaucht oder eingeschrumpft wird.

Es ist besonders vorteilhaft, wenn die Ummantelung in einigen der Abschnitte geringerer Elektrodenbreite Einschnürungen aufweist, z.B. seitliche Kerbungen oder Stanzungen. Diese Einschnürungen können vorteilhaft genutzt werden, um die länglichen Elektroden an diesen Positionen mit Haltemitteln am Fahrzeug zu befestigen (z.B. mit Halteschlaufen, Klammern, Clips). Durch die Halterung in den Einschnürungen ist die Elektrode gegen Verschiebung entlang der Längsachse gesichert. Die Einschnürungen oder Stanzungen verbessern die Flexibilität in diesen Abschnitten weiter. Die Einschnürungen können bei allen Abschnitten mit geringerer Elektrodenbreite ausgeführt sein oder auch nur bei einigen der schmaleren Elektrodenabschnitte.

Vorteilhafte und/oder bevorzugte Ausführungsformen sind in den Unteransprüchen gekennzeichnet.

Die Erfindung wird nun anhand der beiliegenden Figuren näher erläutert.
Figur 1 zeigt die Anordnung einer Ausführungsform der erfindungsgemäßen Sensoranordnung an einem Kraftfahrzeug;
Figur 2 zeigt die Anordnung aus Figur 1 in einer schematischen Aufsicht;
Figur 3a zeigt eine erfindungsgemäße Elektrode zum Einsatz an einem Kraftfahrzeug;
Figur 3b zeigt ein schematisches Ersatzschaltbild der Elektrode aus Figur 3a;

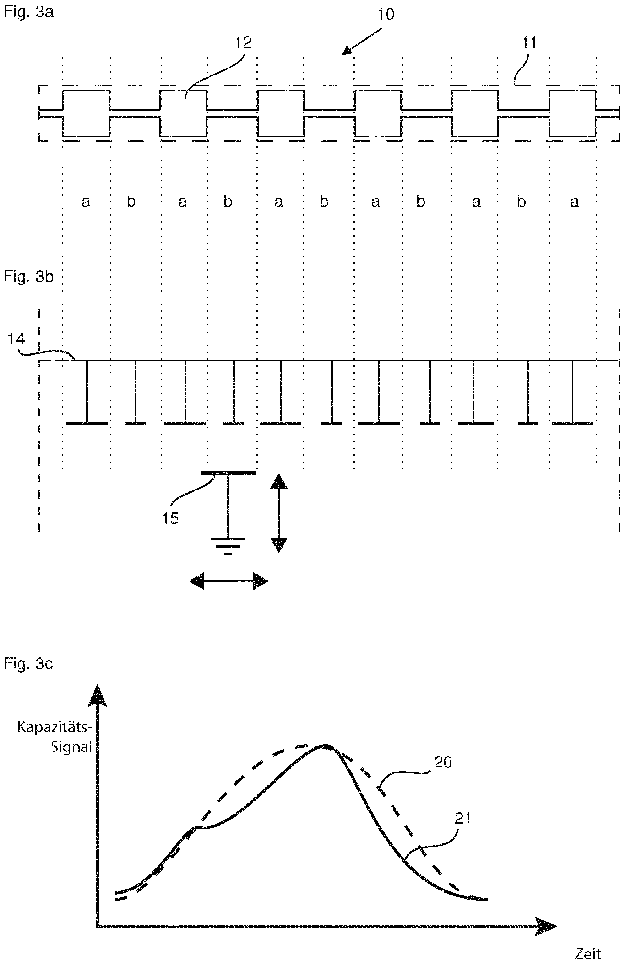

Figur 3b zeigt einen schematischen Signalverlauf bei Detektion einer Betätigungsgeste;

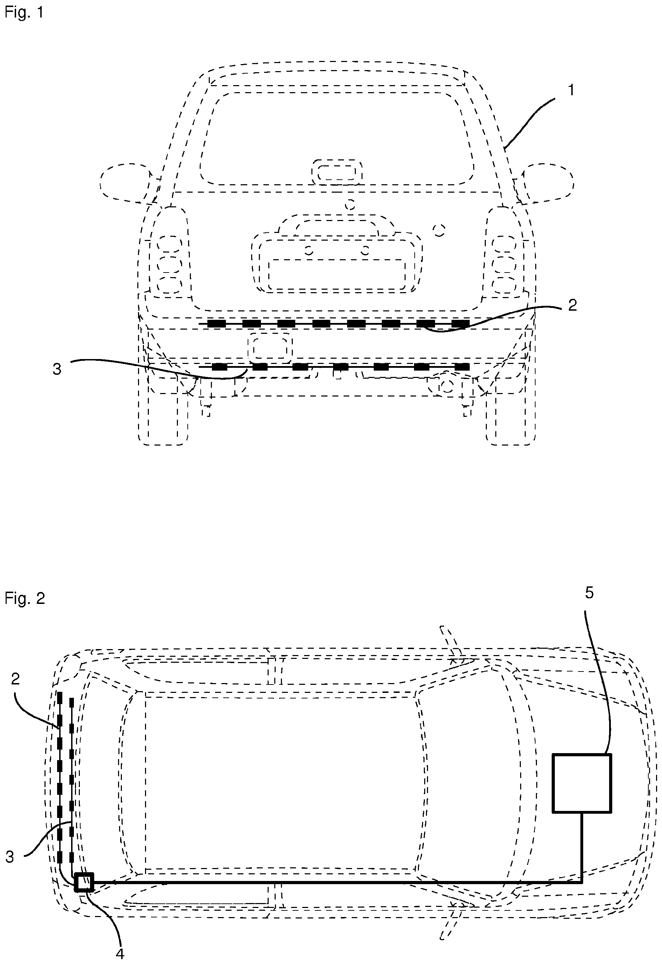

In Figur 1 ist das Heck eines Fahrzeugs 1 gezeigt. Bereich des Heckstossfängers ist eine erfindungsgemäße Sensorelektrodenanordnung 2 angebracht. Unterhalb der Sensorelektrodenanordnung 2 ist eine weitere erfindungsgemäße Sensorelektrodenanordnung 3 mit einem vertikalen und horizontalen Versatz angeordnet. Die Sensorelektrodenanordnungen 2 und 3 sind mit einer Steuer- und Auswerteeinrichtung 4 verbunden. Diese ist nahe der Elektroden 2 und 3 angeordnet. Die Einrichtung 4 ist wiederum mit einer zentralen Fahrzeugsteuereinheit 5 gekoppelt (siehe Figur 2). Die zentrale Steuereinrichtung 5 erhält von der Steuer- und Auswerteeinrichtung 4 ein Signal zur Öffnung der Heckklappe, wobei die Einrichtung 4 die Signale der Elektroden auswertet.

Die Elektroden werden auch über diese Steuer- und Auswerteeinrichtung 4 aufgeladen und deren Kapazitätsänderung bei Annäherung eines Körpers, z.B. eines Bedienerkörperteils wird durch Ladungsauswertung erfasst. Dieses Prinzip eines kapazitiven Sensors ist im Bereich der Kraftfahrzeugtechnik bekannt. Der Verbund aus Elektroden 2, 3 und Steuer- und Auswerteeinrichtung absolviert also die Erfassung und Auswertung von Signalen selbstständig und liefert ein Öffnungssignal.

Die Sensorelektrodenanordnung 3 verläuft im Wesentlichen parallel zu der Sensorelektrodenanordnung 2. Die Ausbildung ist derart, dass die Sensorelektrodenanordnungen 2 und 3 in Richtung der Erstreckung des Stoßfängers Bereiche mit wechselnder Erfassungssensitivität aufweist. Dafür sind die Elektroden der Sensorelektrodenanordnungen abschnittsweise mit verschiedener Breite der Flachseiten ausgebildet. Bereiche größerer Breite der Flachseiten werden durch Bereiche geringerer Breite leitend verbunden. Die Elektroden sind als Flachleiter ausgebildet und weisen in diesem Beispiel über die gesamte Länge eine einheitliche Dicke auf. Die flächigen Seiten sind in Richtung des Erfassungsbereiches der Elektroden ausgerichtet. Die Elektrode 2 ist mit ihrer Flachseite nach hinten, die Elektrode 3 nach unten oder schräg hinten-unten gerichtet. In diesem Beispiel weisen die Elektroden 2 und 3 unterschiedliche Abstände zwischen den sensitiveren Bereichen auf und die sensitiven Bereiche sind außerdem bei Elektrode 2 länger als bei Elektrode 3.

Dank ihrer Flexibilität sind die Elektroden an die Karosserieform des Fahrzeuges problemlos anpassbar und z.B. innen an den Stossfänger mit Klebemitteln oder Clips befestigbar.

Die Sensorelektrodenanordnungen 2 und 3 können sowohl eine Annäherung erfassen (durch absolute Veränderung des erfassten Signals) als auch eine Bewegung eines Körpers entlang der Abschnitte unterschiedlicher Breite. Befindet nämlich ein Körper derart vor der Sensorelektrode, dass mehr Fläche oder breitere Abschnitte mit höherer Erfassungssensitivität hinter Körper liegen als Segmente mit niedrigerer Erfassungssensitivität ist das ermittelte Signal höher als in dem Fall, dass der Körper derart vor der Sensorelektrode angeordnet ist, dass schmalere oder verjüngte Abschnitte mit geringerer Erfassungssensitivität hinter Körper liegen (siehe unten). Bewegt sich der Körper entlang der Anordnung, ist dies durch eine Signalfluktuation, insbesondere Wendepunkte im Signalverlauf erkennbar, welche mit der Auswerteeinrichtung messbar sind.

Die Abschnitte unterschiedlicher Breite sollten in ihrer Längsabmessung auf die gewünschte Erfassungsgenauigkeit abgestimmt sein, sie können z.B. jeweils eine Länge von 5cm bis 30cm aufweisen. Dabei können die schmaleren Bereiche ebenso lang sein wie die breiteren Bereiche, dies ist jedoch nicht erforderlich.

Bei einem Bedienerwunsch kann ein Bediener bspw. seinen Unterschenkel in einer Schwenkbewegung unter den Stossfänger bewegen. Diese Bewegung und Annäherung wird sowohl durch die Sensorelektrode 2, als auch durch die Sensorelektrode 3 erfasst, wobei die Kapazitätsänderung zeitlich wiederholt, z.B. mit einer Kapazitätsermittlung alle 5ms-15ms, abgefragt und die Veränderung ausgewertet wird.

Ein Öffnungskommando wird jedoch nur von der Steuereinrichtung 4 generiert, wenn die Sensorelektrodenanordnungen 2, 3 bei zeitlicher Abfrage nicht eine Querbewegung registrieren, welche oberhalb einer zulässigen Schwelle liegt. Es soll nämlich nur eine gerade, auf das Fahrzeug gerichtete Geste als Öffnungskommando interpretiert werden. Demnach wird die Gesamtheit der erfassten Signale ausgewertet, um eine sichere Interpretation einer Öffnungsgeste zu ermöglichen.

In Figur 3a ist ein Abschnitt einer erfindungsgemäßen Sensorelektrode 10 gezeigt. Eine verformbare Ummantelung 11 aus einem elastischen Material ist gestrichelt dargestellt. In der Ummantelung 11 ist die eigentliche Sensorelektrode 12 als durchgehender elektrischer Leiter angeordnet. Die Sensorelektrode 12 weist Bereiche a mit erhöhter Breite quer zur Längsrichtung und Bereiche b mit verringerter Breite oder Verjüngung quer zur Längsrichtung auf. Die Dicke der Sensorelektrode, also die Erstreckung senkrecht zu der Papierebene, ist in diesem Ausführungsbeispiel über die gesamte Elektrodenlänge identisch. Die Sensorelektrode 12 ist entsprechend durch Stanzen oder Lasern aus einem homogenen Flachleitermaterial erstellt. Alternativ kann ein Flexleiter verwendet werden, um die Elektrode in der erfindungsgemäßen Weise auszubilden. An einem ihrer Enden ist die Sensorelektrode kontaktiert, um mit dem Steuergerät 4 verbunden zu werden.

Zur Verdeutlichung der Funktionsweise ist unter der Figur 3a die Figur 3b gezeigt, welche entlang der Längserstreckung eine Kondensatorplattenanordnung 14 als Modellvorstellung zeigt, die miteinander elektrisch leitend verbundene Kondensatorplatten mit unterschiedlicher Fläche aufweist. Den Bereichen a ist eine Kondensatorplatte mit größerer Fläche zugeordnet und den Bereichen b eine Kondensatorplatte mit kleinerer Fläche. Die Darstellung in Figur 3b dient lediglich dem Verständnis und stellt keine bauliche Gestaltung der Erfindung dar. Es wird jedoch klar, dass bei kapazitiver Kopplung einer beweglichen Kondensatorplatte 15, welche sowohl in Richtung auf die fixierten Kondensatorplatten hin bewegbar ist, als auch seitlich zu diesen bewegbar ist, eine kapazitive Veränderung in der Kondensatoranordnung hervorzurufen ist. Die Kondensatorplatte 15 steht dabei für einen Körperteil eines Bedieners, z. B. den Unterschenkel, welcher sich der Elektrodenanordnung 10 bzw. der Kondensatorplattenanordnung 14 annähert. Je nachdem, welcher Kondensatorfläche der Kondensatorplatte 15 gegenüberliegt, ist eine unterschiedliche Kapazitätsänderung des aus der Anordnung 14 und der Platte 15 gebildeten Kondensators zu erwarten. Bewegt sich die Kondensatorplatte 15 außerdem entlang der Längsrichtung der Elektrode, so liegt er zeitweise einem Kondensator mit geringerer Fläche (in einem Abschnitt b) oder einer Platte mit größerer Fläche (in Abschnitt a) gegenüber. Selbstverständlich liegen in der Realität jederzeit Mischzustände vor. Bewegt sich jedoch die Kondensatorplatte 15 ohne Abstandsänderung zu den gegenüberliegenden Kondensatoranordnungen quer zu diesen von einer Kondensatorplatte mit großer Fläche über eine Kondensatorplatte mit kleinerer Fläche hin zu einer Kondensatorplatte mit wiederum großer Fläche (also von Bereich a über Bereich b zu dem nächsten Bereich a), so wird das Signal, d. h. die Kapazität von einem Maximum über ein Minimum wieder zu einem Maximum ansteigen.

In der Praxis überlagert sich einer herauszufilternden Querbewegung oft noch eine Annäherung auf die Elektrode zu oder von dieser weg. Erkennbar wird eine solche Querbewegung bei der erfindungsgemäßen Elektrode durch Betrachtung des Signalverlaufs.

Dazu zeigt Figur 3c einen beispielhaften Signalverlauf. Der gestrichelt dargestellte Signalverlauf 20 zeigt eine ausschließlich auf die Sensorelektrode in senkrechter Weise hin ausgeführte Bewegung und Rückbewegung, wobei die Kapazitätsänderung auf einen Maximalwert ansteigt (bei maximaler Annäherung) und danach wieder abfällt. Ist dieser Bewegung auf die Elektrode zu einer Querbewegung überlagert, so ergibt sich ein (hier normalisiert dargestellter) Signalverlauf 21, der im Signalverlauf selbst einen Wendepunkt aufweist. Dieser Wendepunkt resultiert daraus, dass von dem Unterschenkel eines Benutzers die Bewegung derart vollzogen wird, dass der Körper zu verschiedenen Zeiten in unterschiedlichen Anteilen in den jeweiligen Abschnitten a oder b vorliegt, sich also quer zu Elektrodenanordnung bewegt. Der Betätigungskick, sofern es überhaupt ein gezielter Betätigungsversuch ist, wird seitlich ausgeführt. Beim Übergang von einem Abschnitt a mit hoher Erfassungssensibilität zu einem Abschnitt b wird trotz der Annäherung des Körpers an die Elektrode allein aufgrund der geringeren Flächenkopplung ein Wendepunkt im Signalverlauf entstehen. Selbst wenn der Maximalwert des Signales genauso erreicht wird, wie bei einer perfekt senkrecht ausgeführten Bewegung, ist die Quererkennung anhand der erfindungsgemäßen ausgebildeten Elektrode detektierbar. Dazu ist lediglich eine Erfassung der Kapazitäten mit ausreichender Zeitauflösung erforderlich, was jedoch nach heutigem Stand der Technik möglich ist. Wir eine solche Signalform ermittelt, so kann die Signalfolge als ungezielte Bewegung verworfen werden. Dabei können selbstverständlich weitere Kriterien, wie z.B. absolute Signalstärke, Extremwerte etc. berücksichtigt werden. Wesentlich ist, dass die erfindungsgemäße Anordnung eine solche differenzierte Auswertung überhaupt erlaubt.

## Patentansprüche

1. Sensoranordnung zur Erfassung von Bewegungsgesten an einem Kraftfahrzeug, mit einer kapazitiven Sensorelektrode (2; 12) und wenigstens einer mit der Sensorelektrode gekoppelten Steuer- und Auswerteeinrichtung (4), die eine Änderung der Kapazität der Sensorelektrode erfasst, wobei die Sensorelektrode (2; 12) als langgestreckte Flachelektrode ausgebildet ist, wobei sich in Längsrichtung sensitivere Elektrodenabschnitte (a) mit einer ersten Flächenbreite mit weniger sensitiven Abschnitten (b) einer zweiten, geringeren Flächenbreite abwechseln, so dass abschnittsweise durchgehend leitende, jedoch unterschiedlich sensitive Elektrodenflächen mit unterschiedlichen Abmessungen gebildet sind,
**dadurch gekennzeichnet,**
**dass** eine verformbare, flache und elektrisch isolierende Ummantelung (11) der Sensorelektrode (12) gebildet ist, wobei eine weitere langgestreckte Elektrode (3) vorgesehen ist, welche mit derselben Steuer- und Auswerteeinrichtung (4) gekoppelt ist, wobei die weitere Elektrode (3) ebenfalls Bereiche unterschiedlicher Flächenbreite aufweist.

2. Sensoranordnung nach Anspruch 1, wobei die Sensorelektroden abwechselnde Bereiche mit paarweise einheitlichen Abmessungen aufweisen, so dass alle breiteren Abschnitte einheitlich ausgebildet sind und alle schmaleren Abschnitte einheitlich ausgebildet sind.

3. Sensoranordnung nach Anspruch 1, wobei die Sensorelektroden in wenigstens einem Abschnitt einen Abschnitt mit gegenüber den übrigen sensitiven Abschnitten vergrößerter Breite oder vergrößerter Längserstreckung aufweist.

4. Sensoranordnung nach einem der vorangehenden Ansprüche, wobei die Ummantelung aus einem elastischen Material gebildet ist und wobei Markierungen auf der Ummantelung angeordnet sind, welche die sensitiveren und weniger sensitiven Bereiche der innenliegenden Elektrode anzeigen.

5. Sensoranordnung nach Anspruch 1, wobei die Steuer- und Auswerteeinrichtung ausgebildet ist, um zeitaufgelöste Kapazitätswerte für jede der Elektroden zu ermitteln und wobei sie zur Erkennung von Wendepunkten im Signalverlauf der Kapazitätswerte ausgebildet ist.

## Claims

1. A sensor arrangement for detecting motion gestures on a motor vehicle, with a capacitive sensor electrode (2; 12) and at least one control and evaluation device (4) coupled to the sensor electrode (2, 12) for detecting a change in capacity of the sensor electrode, wherein the sensor electrode (2, 12) is formed as an elongated flat electrode, wherein more sensitive electrode sections (a) having a first areal width alternate in longitudinal direction with less sensitive sections (b) having a second, lesser areal width, so that sections of continuously conductive electrode surfaces are formed, which however have different sensitivities and different dimensions, **characterised in that**
a deformable, flat and electrically insulating sheathing (11) of the sensor electrode (12) is formed, wherein a further elongated electrode (3) is provided, which is coupled to the same control and evaluation device (4), wherein the further electrode (3) also comprises regions of different areal width.

2. The sensor arrangement according to claim 1, wherein the sensor electrodes comprise alternating regions of pair-wise uniform dimensions, so that all wider sections are formed uniformly and all narrower sections are formed uniformly.

3. The sensor arrangement according to claim 1, wherein the sensor electrodes, in at least one section, comprise a section which compared to the other sensitive sections, has an enlarged width or enlarged longitudinal extension.

4. The sensor arrangement according to one of the preceding claims, wherein the sheathing is formed from an elastic material and wherein markings are arranged on the sheathing which indicate the more sensitive and less sensitive regions of the inboard electrode.

5. The sensor arrangement according to claim 1, wherein the control and evaluation device is configured to ascertain time-resolved capacity values for each of the electrodes and wherein it is configured to detect turning points in the signal progression of the capacity values.

## Revendications

1. Ensemble capteur pour saisir des gestes de mouvement au niveau d'un véhicule automobile, avec une électrode de capteur capacitive (2,12) et au moins un dispositif de commande et d'exploitation (4) couplé à l'électrode de capteur, qui saisit une variation de la capacité de l'électrode de capteur, l'électrode de capteur (2,12) étant constituée comme une électrode plate allongée, des sections d'électrode (a) plus sensibles dans la direction longitudinale avec une première largeur de surface alternant avec moins de sections sensibles (b) d'une deuxième largeur de surface plus faible de telle sorte que des surfaces d'électrode conductrices en permanence par section mais toutefois différemment sensibles sont formées avec des dimensions différentes,
**caractérisé en ce qu'**une enveloppe (11) déformable, plate et électro-isolante de l'électrode de capteur (12) est formée, une autre électrode allongée (3) étant prévue, laquelle est couplée avec le même dispositif de commande et d'exploitation (4), l'autre électrode (3) comportant également des zones de largeur de surface différente.

2. Ensemble capteur selon la revendication 1, les électrodes de capteurs comportant des zones alternantes avec des dimensions uniformes par paires de telle sorte que toutes les sections plus larges sont constituées de façon uniforme et toutes les sections plus étroites sont constituées de façon uniforme.

3. Ensemble capteur selon la revendication 1, les électrodes de capteur comportant dans au moins une section, une section avec une largeur agrandie par rapport aux autres sections sensibles ou une extension longitudinale agrandie.

4. Ensemble capteur selon l'une quelconque des revendications précédentes, l'enveloppe étant constituée d'un matériau élastique et des repères étant disposés sur l'enveloppe, lesquels indiquent les zones plus sensibles et moins sensibles de l'électrode située à l'intérieur.

5. Ensemble capteur selon la revendication 1, le dispositif de commande et d'exploitation étant constitué pour déterminer des valeurs de capacité définies dans le temps pour chacune des électrodes et celui-ci étant constitué pour identifier des points d'inflexion dans l'allure des signaux des valeurs de capacité.
